Europäisches Patentamt

European Patent Office

Office européen des brevets

(11) Veröffentlichungsnummer: **0 205 836 B1**

(12) **EUROPÄISCHE PATENTSCHRIFT**

(45) Veröffentlichungstag der Patentschrift: 31.07.91

(51) Int. Cl.⁵: **H03H 17/04**

(21) Anmeldenummer: **86106042.4**

(22) Anmeldetag: **02.05.86**

(54) **Digitales Rekursiv-Filter.**

(30) Priorität: **22.06.85 DE 3522411**

(43) Veröffentlichungstag der Anmeldung:
**30.12.86 Patentblatt 86/52**

(45) Bekanntmachung des Hinweises auf die
Patenterteilung:
**31.07.91 Patentblatt 91/31**

(84) Benannte Vertragsstaaten:
**AT CH FR GB LI NL**

(56) Entgegenhaltungen:
**EP-A- 0 135 606**

**1978 IEEE INTERNATIONAL SYMPOSIUM ON
CIRCUITS AND SYSTEMS PROCEEDINGS,
New York, 17.-19. Mai 1978, Seiten 1023-1028,
IEEE, New York, US; D. MITRA et al.:
"Summary of results on controlled rounding
arithmetics, for direct form digital filters,
that eliminate all self-sustained oscillations"**

**IEE PROCEEDINGS SECTIONS A-1, Band 130,
Nr. 3, Teil G, Juni 1983, Seiten 69-77, Old
Woking, Surrey, GB; L.E. TURNER:
"Elimination of constant-input limit cycles in
recursive digital filters using a generalised
minimum norm"**

**IEEE TRANSACTIONS ON CIRCUITS AND SY-
STEMS, Band CAS-27, Nr. 1, Januar 1980,
Seiten 50-53, IEEE, New York, US; L.E. TUR-
NER et al.: "Elimination of granularity and
overflow limit cycles in minimum norm recursive digital filters"**

(73) Patentinhaber: **ANT Nachrichtentechnik GmbH
Gerberstrasse 33
W-7150 Backnang(DE)**

(72) Erfinder: **Göckler, Heinz, Dipl.-Ing.
Elbinger Strasse 52
W-7150 Backnang(DE)**

## Beschreibung

Die Erfindung betrifft ein digitales Rekursiv-Filter gemäß Oberbegriff eines der Ansprüche 1 bis 2.

Solche Filter sind bekannt und beispielsweise beschrieben in dem Aufsatz "Elimination of Granularity and Overflow Limit Cycles in Minimum Norm Recursive Digital Filters" von Turner und Bruton in IEEE Transactions on circuits and systems, Vol. CAS-27, No. 1, January 1980, Seiten 50 bis 53.

In einem rekursiven Digital-Filter treten als Folge der endlichen Signalwortlänge 2 Arten von Nichtlinearitäten auf.

Die 1. Art hat ihre Ursache in den Rundungs- und/oder Schneideoperationen, die wegen der Granularität der Signale im Anschluß an gewisse arithmetische Operationen auszuführen sind.

Die 2. Art wird dadurch hervorgerufen, daß Ergebnisse arithmetischer Operationen den Zahlenbereich überschreiten, der durch die jeweilige Signalwortlänge vorgegeben ist.

Man spricht in diesem Zusammenhang auch von sogenannten Überlauf-Nichtlinearitäten.

Als Folge der Nichtlinearitäten können bekanntlich parasitäre Schwingungen auftreten, durch welche die Funktionsfähigkeit eines Digitalfilters stark beeinträchtigt werden kann. Gemäß der Ursache ihres Entstehens lassen sich diese Schwingungen in Granularitäts- bzw. Grenzzyklus- und Überlauf-Schwingungen unterteilen.

Die zuletzt genannten Schwingungen müssen unter allen Umständen vermieden werden, da ihre Amplituden in der Größenordnung der Signale liegen. In viel en Fällen wird man auch an einer Unterdrückung der Granularität- bzw. Grenzzyklus-Schwingungen interessiert sein, zumal ihre Leistungen ebenfalls sehr hoch und ihre Spektren nur auf wenige Frequenzen konzentriert sein können.

Durch die deutsche Patentschrift DE-C-24 18 923 sind digitale Rechnerfilter bekannt geworden, bei welchen die genannten Grenzzyklus-Schwingungen wirksam unterbunden werden, wenn bestimmte Bedingungen für diese digitalen Rechnerfilter eingehalten werden. Zu diesen Bedingungen gehört, daß die von jedem Schaltungsabschnitt des Filters absorbierte Pseudo-Leistung

$$P(t) = \sum_{\nu=1}^{n} G_\nu \left[ a_\nu^2(t) - b_\nu^2(t) \right]$$

gleich oder größer ist als derjenige Wert der Pseudo-Leistung, der sich ergibt, wenn unter Fortlassung der Rundungs- bzw. Schneideschaltungen bzw. der Überlaufkorrektur die arithmetischen Operationen exakt ausgeführt werden, wobei $\nu$ die Nummer der Tore (1 bis n),

$a_\nu(t)$ die Eingangsgröße zum Zeitpunkt t im $\nu$. Tor,

$b_\nu(t)$ die Ausgangsgröße zum Zeitpunkt t im $\nu$. Tor und

$G_\nu$ eine dem $\nu$. Tor zugeordnete positive Größe sind.

Ein solches n-Tor wird pseudopassiv genannt.

Als inkrementalpseudopassiv werden Filter bezeichnet, bei denen die von jedem Schaltungsabschnitt absorbierte inkrementale Pseudoleistung gleich oder größer ist als derjenige Wert der inkrementalen Pseudoleistung, der sich ergibt, wenn unter Fortlassung der Überlaufkorrektur die arithmetischen Operationen ausgeführt werden.

Die inkrementale Pseudoleistung errechnet sich aus der vorhin angegebenen Pseudoleistung, indem man die Eingangs- bzw. die Ausgangsgrößen $a_\nu(t)$ bzw. $b_\nu(t)$ durch die Inkremente $\Delta a_\rho(t)$ bzw $\Delta b_\rho(t)$ ersetzt.

Wenn diese Bedingung eingehalten wird, so ist das digitale System frei von Überlauf-Schwingungen und gesteigert antwortstabil. Antwortstabil heißt, daß eine durch einen Überlauf hervorgerufene Störung auch bei nicht verschwindender Erregung stets abklingt, sofern unter idealen linearen Bedingungen Überläufe nur vorübergehend auftreten.

Gesteigerte Antwortstabilität bedeutet, daß permanent auftretende geringfügige Überläufe auch nur geringfügige Störungen des Ausgangssignals zur Folge haben.

Der Erfindung lag die folgende Aufgabe zugrunde, die eingangs genannte Zustandsvariablen-Filterstruktur bei wirtschaftlich vertretbarem Aufwand so zu realisieren, daß die Bedingung inkrementale Pseudopassivität und die dadurch implizierte Antwortstabilität mit hoher Wahrscheinlichkeit erfüllt ist.

Diese Aufgabe wird gelöst durch die Merkmale der Ansprüche 1 oder 2.

Die Vorteile sind darin zu sehen, daß mit der angegebenen Filterstruktur erstmalig eine explizite, nicht nur theoretische, schaltungsmäßige Lösung geboten wird, welche die Bedingung inkrementale Pseudopassivität und die dadurch implizierte Antwortstabilität bei wirtschaftlich vertretbarem Aufwand mit sehr hoher Wahrscheinlichkeit erfüllt.

Nur bei einem ganz speziellen Signalmuster, dessen Auftreten jedoch nahezu unwahrscheinlich ist, kann die Bedingung inkrementale Pseudopassivität verletzt werden, allerdings in einer nur geringfügigen Weise, so daß man davon auszugehen hat, daß die Auswirkungen auf das Ausgangssignal ebenfall nur geringfügig sind. Hinzukommt, daß dieses spezielle Signalmuster auch eine gewisse Dauer aufweisen müßte, um den Aufbau von Grenzzyklen zu bewirken, was ebenfalls mit hoher Wahrscheinlichkeit nicht zutrifft.

Es folgt nun die Beschreibung der Erfindung anhand der Figuren.

Die Figur 1a zeigt eine Zustandsvariablen-Filter-Blockstruktur 2. Ordnung und die zugehörige Figur 1b die Bestimmung des für Fest- und Gleitkomma-Arithmetik gleichen Signalkorrekturterms.

Die Figur 2 gibt eine alternative inkremental pseudopassive Realisierung einer Zustandsvariablen-Filter-Blockstruktur 2. Ordnung wieder, die ohne Signalkorrektur arbeitet.

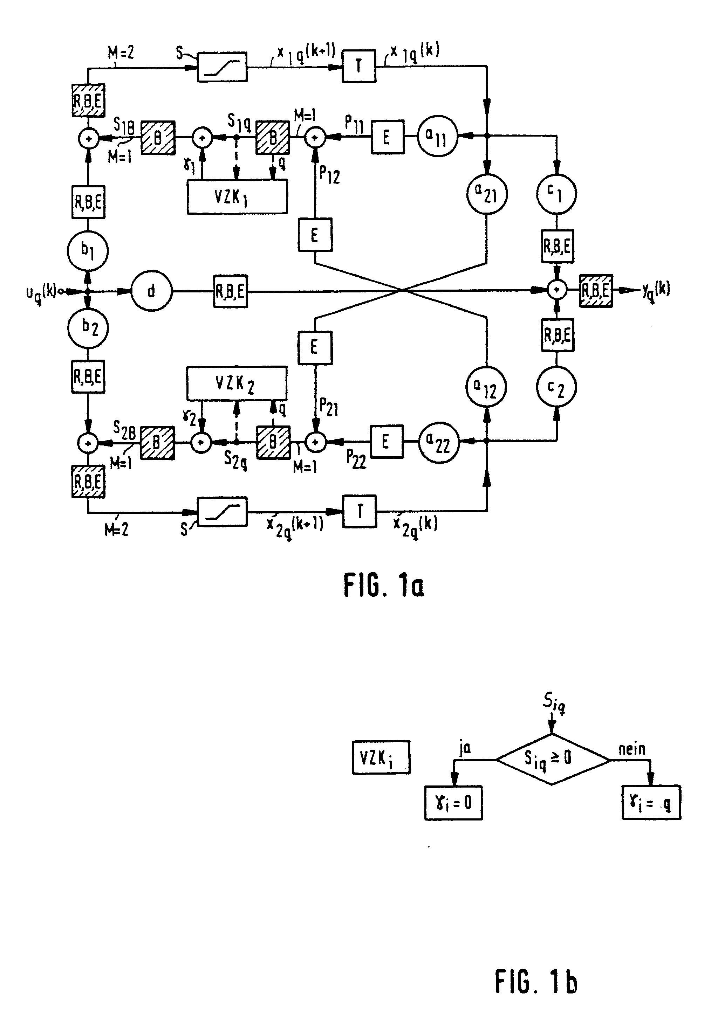

Die in Fest- oder Gleitkomma-Arithmetik ausgeführte Zustandsvariablen-Filter-Blockstruktur 2. Ordnung gemäß Figur 1a enthält einen Transversalzweig und 2 Rekursivzweige mit jeweils einem Verzögerungsglied T, dessen Ausgangssignal in einer ersten Schleife auf seinen eigenen Eingang und in einer zweiten Schleife jeweils auf den Eingang des anderen Verzögerungsgliedes rückgeführt wird. In der ersten Schleife wird das Ausgangssignal x1q(k) mit a11 bewertet, dann einer Zweier-Komplement-Schneideoperation E unterzogen. Anschließend erfolgt die Vereinigung mit dem Ausgangssignal des anderen Verzögerungsgliedes, welches Signal mit a12 bewertet und einer Zweier-Komplement-Schneideoperation E unterzogen wird. Das Summensignal S1b wird zu dem mit b1 bewerteten Eingangssignal uq(k), welches anschließend einer Rundungs- bzw. Schneideoperation unterzogen wird, addiert, dann einer Sättigungskennlinie (Begrenzer S) unterzogen und sodann als Eingangssignal x1q(k + 1) des Verzögerungsgliedes T verwendet.

Um festzustellen, ob am Begrenzer S die Signale unverändert weitergegeben werden können oder auf positive oder negative Aussteuergrenzen zu begrenzen sind, sind für das Signal S1B ein Überlaufbit (M = 1) und für das Begrenzer-Eingangssignal zwei Überlaufbits (M = 2) vorgesehen.

In entsprechender Weise sind die 1. und 2. Schleife für das 2. Verzögerungsglied aufgebaut.

Die beiden Ausgangssignale x1q(k) und x2q(k) der Verzögerungsglieder T werden mit c1 bzw. c2 bewertet und anschließend einer Rundungs- oder Schneideoperation unterzogen.

Mittels eines Summierers werden beide Signale und das Ausgangssignal des Transversalzweiges d summiert und anschließend einer Rundungs- bzw. Schneideoperation zum Ausgangssignal yq(k) unterzogen.

Die Signalkorrektur VZK erfolgt gemäß Figur 1a jeweils nach der Vereinigung der beiden Rekursivsignale Pii und Pij. Das vereinigte Signal Siq wird auf Werte kleiner Null untersucht. Ist das der Fall, so wird zum Signal Siq der Korrekturterm i = qiS hinzuaddiert. qiS ist die Quantisierungsstufe des Signals Siq.

Selbstverständlich kann die Signalkorrektur VZKi auch an anderer Stelle des Rekursivzweiges vorgenommen werden, beispielsweise vor oder hinter dem Begrenzer S oder dem Verzögerungsglied T.

Wird die Filterstruktur gemäß Figur 1a in Gleitkomma-Arithmetik ausgeführt, so müssen zusätzlich die Operationen des Rundens R, des Betragschneidens B oder des Zweierkomplementschneidens E gemäß der schraffierten Blöcke durchgeführt werden. Diese Operationen haben hinter jeder Addition bzw. Summierung zu erfolgen, wobei die Wortlängenverkürzung nach der Addition der beiden Rekursivsignale Pii und Pij jeweils die Betragsschneideoperation B zu sein hat.

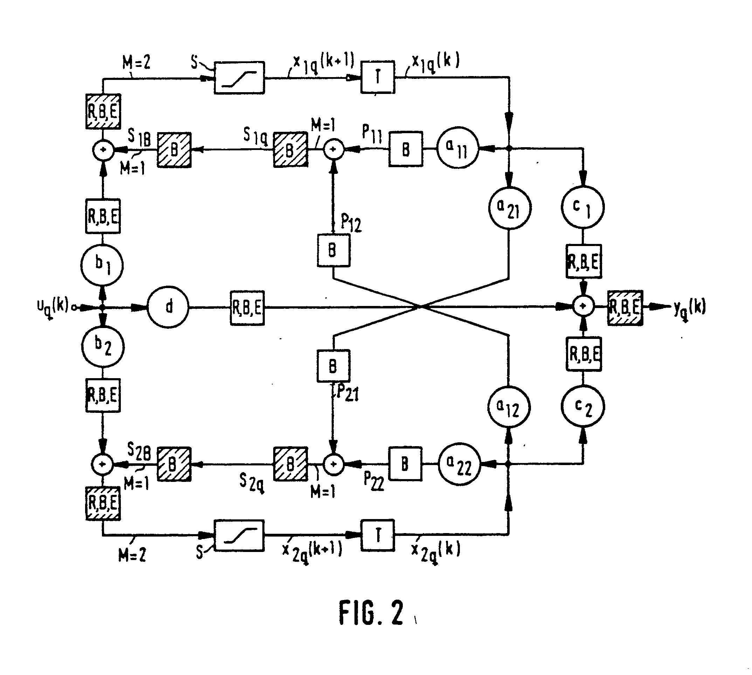

Die Struktur der Figur 2 entspricht derjenigen nach Figur 1a, einziger Unterschied ist, daß nach den Bewertungen der Rekursivschleifen-Signale jeweils nicht eine Zweierkomplementschneideoperation sondern eine Betragsschneideoperation B erfolgt. Eine Signalkorrektur entfällt ganz, so daß diese Lösung sehr aufwandsgünstig ist.

## Patentansprüche

1. Digitales Rekursiv-Filter in Zustands-Raum-Struktur, wobei das mit b1 und b2 bewertete Eingangssignal u(k) zwei Verzögerungsgliedern zugeführt wird, deren Ausgangssignale mit der Bewertung a11 bzw. a22 jeweils auf ihren Eingang rückgeführt sind und mit den Bewertungen a21 bzw. a12 jeweils auf den Eingang des anderen Verzögerungsgliedes rückgeführt sind und mit c1 bzw. c2 bewertet zum Ausgangssignal y(k) zusammengefaßt sind (Filter-Block zweiter Ordnung), mit vorgegebener Signalwortlänge, in Fest- oder Gleitkomma-Arithmetik dadurch gekennzeichnet, daß nach der Bewertung mit a11, a12, a21 und a22 die Signale jeweils der Operation des Zweier-Komplement-Endschneidens (E) und nach jeder anderen Bewertung einer Schneide- oder Rundungsoperation (R, B, E) unterzogen werden, daß das Ein- (Xiq(k + 1)) oder Ausgangssignal (Xiq(k)) der Verzögerungsglieder (T) jeweils einer Sättigungskennlinie (Begrenzer S) unterzogen werden und daß das Ein- oder Ausgangssignal der Verzögerungsglieder (T) oder der Begrenzer (S) oder die auf den Eingang der Verzögerungsglieder rückgeführten Signale (Siq) jeweils einer Signalkorrektur (VZKi) unterworfen werden, indem bei negativem Signal (Siq <0) diesem seine Quantisierungsstufe (q)

3

hinzuaddiert wird (Figur 1).

2. Digitales Rekursiv-Filter in Zustands-Raum-Struktur, wobei das mit b1 und b2 bewertete Eingangssignal u(k) zwei Verzögerungsgliedern zugeführt wird, deren Ausgangssignale mit der Bewertung a11 bzw. a22 jeweils auf ihren Eingang rückgeführt sind und mit den Bewertungen a21 bzw. a12 jeweils auf den Eingang des anderen Verzögerungsgliedes rückgeführt sind und mit c1 und c2 bewertet zum Ausgangssignal y(k) zusammengefaßt sind (Filter-Block zweiter Ordnung), mit vorgegebener Signalwortlänge, in Fest- oder Gleitkomma-Arithmetik, dadurch gekennzeichnet, daß nach der Bewertung mit a11, a12, a21 und a22 die Signale jeweils der Operation des Betragsschneidens (B) und nach jeder anderen Bewertung einer Schneide- oder Rundungsoperation (R, B, E) unterzogen werden und

daß das Ein- (Xiq(k+1)) oder Ausgangssignal (Xiq(k) der Verzögerungsglieder (T) jeweils einer Sättigungskennlinie (Begrenzer S) unterzogen werden (Fig. 2).

**Claims**

1. Digital recursive filter in phase space structure, wherein the input signal u(k) weighted by b1 and b2 is fed to two delay members, the output signals of which are fed back with the weighting a11 and a22 respectively to their input and with the weighting a21 and a12 respectively to the input of the other delay member and, weighted by c1 and c2 respectively, combined into the output signal y(k) (filter block of second order), of preset signal word length and in fixed or floating decimal point arithmetic, characterised thereby, that the signals after the weighting with a11, a12, a21 and a22 are respectively subjected to the operation of the complement-of-two end cutting (E) and after each other weighting are subjected to a cutting or rounding operation (R, B, E), that the input signal (Xiq(k+1)) or output signal (Xiq(k)) of the delay members (T) are each subjected to a respective saturation characteristic (limiters S) and that the input signal and the output signal of the delay members (T) or the limiters (S) or the signals (Xiq) fed back to the input of the delay members are each subjected to a signal correction (VZKi) in that in the case of a negative signal (Xiq < 0), its quantising step (q) is added to this (Figure 1).

2. Digital recursive filter in phase space structure, wherein the input signal u(k) weighted by b1 and b2 is fed to two delay members, the output signals of which are fed back with the weighting a11 and a22 respectively to their input and with the weightings a21 and a12 respectively to the input of the other delay member and, weighted by c1 and c2 respectively, combined into the ouput signal y(k) (filter block of second order), of preset signal word length and in fixed or floating decimal point arithmetic, characterised thereby, that the signals after the weighting with a11, a12, a21 and a22 are respectively subjected to the operation of the amount cutting (B) and after each other weighting are subjected to a cutting or rounding operation (R, B, E) and that the input signal (Xiq(k+1)) or output signal (Xiq(k)) of the delay members (T) are each subjected to a respective saturation characteristic (limiters S) (Figure 2).

**Revendications**

1. Filtre numérique travaillant en mode récurrent dans une structure spatiale d'état, dans laquelle le signal d'entrée u(k) pondéré par b1 et b2 est amené à deux éléments à retard dont les signaux de sortie sont chacun renvoyés, avec la pondération a11 ou a22, à leur entrée et, avec les pondérations a21 ou a12, respectivement à l'entrée de l'autre élément à retard, puis, pondérés par c1 ou c2, sont regroupés pour donner le signal de sortie y(k) (bloc de filtre du deuxième ordre), avec une longueur prescrite de mot du signal, en arithmétique à virgule fixe ou flottante, caractérisé par le fait qu'après la pondération a11, a12, a21, et a22, les signaux sont respectivement soumis à l'opération de suppression de la retenue dans un calcul par complémentation à deux (E) et, après chacune des autres pondérations, à une opération de coupure ou d'arrondi (R, B, E),

par le fait que le signal d'entrée (Xiq(k+1)) ou le signal de sortie (Xiq(k)) des éléments à retard (T) sont respectivement soumis à une caractéristique de saturation (limiteurs S) et

par le fait que le signal d'entrée ou le signal de sortie des éléments à retard (T) ou des limiteurs (S) ou bien les signaux (Siq) renvoyés à l'entrée des éléments à retard sont respectivement soumis à une correction du signal (VZKI) en ce sens qu'en cas de signal négatif (Siq < 0), on lui ajoute son étage de numérisation (q) (figure 1).

2. Filtre numérique travaillant en mode récurrent dans une structure spatiale d'état, dans laquelle le signal d'entrée u(k) pondéré par b1 et b2 est amené à deux éléments à retard dont les signaux de sortie sont chacun renvoyés, avec la pondération a11 ou a22, à leur entrée et, avec les pondérations a21 ou a12, respectivement à l'entrée de l'autre élément à retard, puis, pondérés par c1 ou c2, sont regroupés pour donner le signal de sortie y(k) (bloc de filtre du deuxième ordre), avec une longueur prescrite de mot du signal, en arithmétique à virgule fixe ou flottante, caractérisé par le fait qu'après la pondération par a11, a12, a21 et a22, les signaux sont respectivement soumis à l'opération de coupure de la valeur absolue (B) et, après chacune des autres pondérations à une opération de coupure ou d'arrondi (R, B, E) et

par le fait que le signal d'entrée (Xiq(k + 1)) ou le signal de sortie (Xiq(k)) des éléments à retard (T) sont respectivement soumis à une caractéristique de saturation (limiteurs S) (figure 2).

FIG. 1a

FIG. 1b

FIG. 2